# FASCICULE DE BREVET EUROPEEN

(11) **EP 3 276 385 B1**
(45) Date de publication et mention de la délivrance du brevet: **26.09.2018**
(21) Numéro de dépôt: 17180850.4
(22) Date de dépôt: 12.07.2017
(51) Int. Cl.: G02B 6/12, H01L 31/0232, H01L 31/105

(54) **PROCÉDÉ DE FABRICATION D'UN GUIDE À ONDE LENTE EN GERMANIUM ET PHOTODIODE INCORPORANT CE GUIDE À ONDE LENTE**
HERSTELLUNGSVERFAHREN EINES LANGSAMEN WELLENLEITERS AUS GERMANIUM, UND FOTODIODE, IN DIE EIN SOLCHER LANGSAMER WELLENLEITER EINGEBAUT IST
METHOD FOR MANUFACTURING A GERMANIUM SLOW WAVE GUIDE AND PHOTODIODE INCORPORATING SAID SLOW WAVE GUIDE

(30) Priorité: 28.07.2016 FR 1657330
(43) Date de publication de la demande: 31.01.2018
(73) Titulaire: COMMISSARIAT À L'ÉNERGIE ATOMIQUE ET AUX ÉNERGIES ALTERNATIVES, 75015 Paris (FR)
(72) Inventeur: HASSAN, Karim, 89470 Moneteau (FR); FOWLER, Daivid, 38950 Saint Martin Le Vinoux (FR); KOPP, Christophe, 38120 Fontanil-Cornillon (FR); SZELAG, Bertrand, 38320 Herbeys (FR)
(74) Mandataire: Colombo, Michel

(56) Documents cités:
- US-A1- 2007 104 441
- US-A1- 2015 293 302
- US-B2- 9 035 409
- TOSHIHIKO BABA: "Slow light tuning in photonic crystals", SPIE - INTERNATIONAL SOCIETY FOR OPTICAL ENGINEERING. PROCEEDINGS, vol. 8808, 11 septembre 2013 (2013-09-11), page 88081A, XP055362617, US ISSN: 0277-786X, DOI: 10.1117/12.2023555 ISBN: 978-1-5106-0753-8

## Description

L'invention concerne un procédé de fabrication d'un guide à onde lente en germanium sur une dalle en silicium. L'invention concerne également un procédé de fabrication d'une photodiode mettant en oeuvre ce procédé de fabrication d'un guide à onde lente ainsi qu'une photodiode fabriquée à l'aide de ce procédé.

La demande US9035409B2 décrit une photodiode comportant un guide à onde lente. De plus, la demande US9035409B2 décrit un procédé de fabrication du guide à onde lente en germanium sur une dalle en silicium s'étendant principalement dans un plan appelé « plan de la dalle ». Ce guide à onde lente comporte une section horizontale, parallèle au plan de la dalle, qui présente un même motif répété avec un pas régulier le long d'un axe optique, ces motifs étant disposés de façon symétrique de part et d'autre de l'axe optique de manière à ce que cet agencement de motifs ralentisse la propagation du signal optique le long de l'axe optique à l'intérieur du guide à onde lente.

Dans les modes de réalisation de la demande US9035409B2, les motifs du guide à onde lente sont des trous traversant de part en part un ruban central en germanium ou des encoches réalisées dans des flancs latéraux de ce ruban central.

Pour fabriquer un tel guide à onde lente et une telle photodiode, la demande US9035409B2 enseigne que les motifs du guide à onde lente sont directement gravés dans le germanium.

L'incorporation d'un tel guide à onde lente dans une photodiode présente notamment l'avantage d'augmenter de façon très significative le coefficient d'absorption de la photodiode, c'est-à-dire la quantité de lumière absorbée par unité de longueur. Ce coefficient est typiquement exprimé en dB/µm.

Toutefois, il a été observé que le germanium dans lequel ont été gravés les motifs présente de nombreux défauts de sorte que l'efficacité de la photodiode de la demande US9035409B2 pourrait encore être améliorée s'il était possible de fabriquer un tel guide à onde lente en germanium mais avec moins de défauts. L'efficacité d'une photodiode est le rapport entre la puissance du courant généré par la photodiode lorsqu'un signal optique est détecté, divisé par la puissance du signal optique reçu sur l'entrée de cette photodiode.

De l'état de la technique est également connu de :
- US2015/293302A1,
- Thoshihiko Baba : « Slow light tuning in photonic crystals », SPIE INTERNATIONAL SOCIETY FOR OPTICAL ENGINEERING, Proceedings, Vol. 8808, page 88081A, 11/09/2013,
- US2007/104441A1.

L'invention vise donc à proposer un procédé de fabrication d'un guide à onde lente en germanium sur une dalle en silicium qui permet d'obtenir un guide à onde lente présentant moins de défauts que celui obtenu à l'aide du procédé décrit dans la demande US9035409B2. Elle a donc pour objet un tel procédé conforme à la revendication 1.

Les inventeurs ont observé qu'une partie importante des défauts du guide à onde lente fabriqué selon le procédé de la demande US9035409B2 sont causés par l'opération de gravure des motifs dans le germanium.

Le procédé ci-dessus de fabrication du guide à onde lente permet de structurer les motifs du guide à onde lente sans qu'il soit nécessaire pour cela de recourir à une opération de gravure du germanium. On obtient donc un guide à onde lente en germanium qui présente des motifs aptes à ralentir la propagation du signal optique tout présentant peu de défauts.

L'invention a également pour objet un procédé de fabrication d'une photodiode conforme à la revendication 2.

Lorsqu'une photodiode est fabriquée en mettant en oeuvre le procédé revendiqué, le guide à onde lente en germanium de cette photodiode présente moins de défauts dans la zone d'absorption maximum que s'il avait subi une opération de gravure. Par conséquent, l'efficacité de la photodiode fabriquée par le procédé revendiqué est meilleure.

L'invention a également pour objet une photodiode fabriquée par le procédé revendiqué de fabrication.

Les modes de réalisation de la photodiode peuvent présenter une ou plusieurs des caractéristiques des revendications dépendantes.

Les modes de réalisation de la photodiode peuvent présenter un ou plusieurs des avantages suivants :
- En équipant la photodiode de deux entrées, il est possible de l'utiliser pour détecter deux signaux optiques différents. Cela permet donc de diviser par deux le nombre de photodiodes nécessaires pour faire ce travail. De plus, grâce à la présence du guide à onde lente interposé entre ces deux entrées, la diaphonie entre ces entrées est très fortement limitée, ce qui rend possible l'utilisation pratique d'une telle photodiode à deux entrées.
- Le fait d'utiliser des dents dont la longueur est supérieure à la largeur du ruban central du guide à onde lente permet d'améliorer le taux d'absorption du signal optique guidé. En effet, cette conformation laisse le ruban central inchangé de sorte que la totalité du volume du ruban central est exploité pour récupérer des photons. A l'inverse, dans les modes de réalisation de la demande US9035409B2, les motifs diminuent le volume du ruban central. Le fait d'accroître ce taux d'absorption permet, à performance identique, de concevoir des photodiodes plus courtes.
- Le fait d'utiliser des dents au moins deux fois plus longue que la largeur du ruban central permet en plus d'augmenter la largeur spectrale de la bande interdite. La bande interdite est ici définie comme étant la bande de longueurs d'onde à l'intérieur de laquelle l'atténuation du signal optique dépasse -27 dB.
- Le fait que les bords dopés de la cavité soient directement en contact mécanique et électrique avec les flancs dopés du guide à onde lente limitent l'intensité du courant d'obscurité (« dark current » en anglais) dans la photodiode.
- Le fait d'avoir la sortie du premier guide d'onde directement en contact avec l'entrée du guide à onde lente limite les pertes causées par le couplage optique entre la sortie de ce premier guide d'onde et l'entrée du guide à onde lente.
- Le fait que l'épaisseur du guide à onde lente soit égale à la profondeur de la cavité dans laquelle il est reçu permet de fabriquer une photodiode très plane et donc peu encombrante et compatible avec les interconnexions électriques utilisées couramment en électronique.

L'invention sera mieux comprise à la lecture de la description qui va suivre, donnée uniquement à titre d'exemple non limitatif et faite en se référant aux dessins sur lesquels :
- La figure 1 est une illustration schématique, en perspective, d'une photodiode ;
- La figure 2 est une illustration schématique et partielle, en vue de dessus, de la photodiode de la figure 1 ;
- La figure 3 est une illustration schématique, en vue de dessus, d'une dent d'un guide à onde lente de la photodiode de la figure 1 ;
- Les figures 4 et 5 sont des illustrations schématiques, en coupe transversale à deux endroits différents, du guide à onde lente de la photodiode de la figure 1 ;
- La figure 6 est un graphe représentant le taux de transmission de la photodiode de la figure 1 en fonction de la longueur d'onde du signal optique et pour différentes longueurs des dents de la figure 3;
- La figure 7 est une illustration schématique d'un dispositif incorporant la photodiode de la figure 1 ;
- La figure 8 est un organigramme d'un procédé de fabrication de la photodiode de la figure 1 ;
- Les figures 9 à 15 sont des illustrations schématiques, en coupe transversale, de différents états de fabrication de la photodiode de la figure 1 ;
- Les figures 16 et 17 sont des illustrations schématiques et partielles, en vue de dessus, d'un troisième et d'un quatrième modes de réalisation d'une photodiode.

Dans ces figures, les mêmes références sont utilisées pour désigner les mêmes éléments. Dans la suite de cette description, les caractéristiques et fonctions bien connues de l'homme du métier ne sont pas décrites en détail.

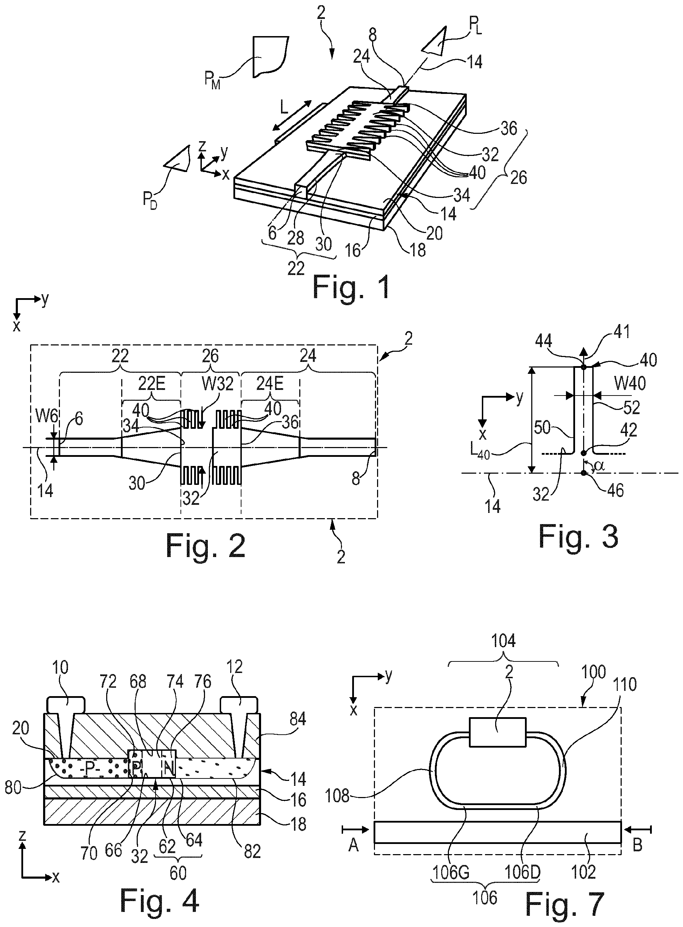

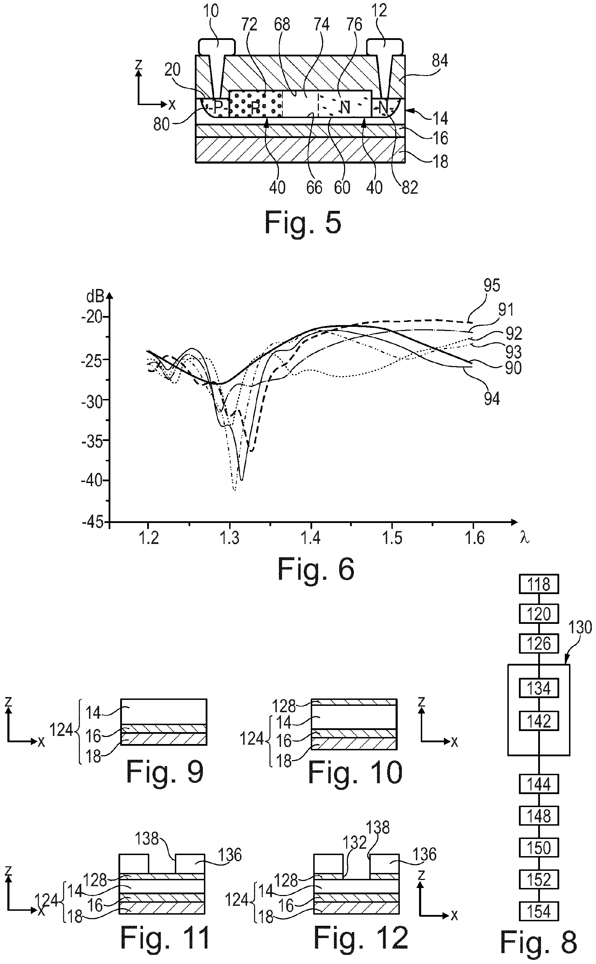

La figure 1 représente une photodiode 2 à deux entrées 6 et 8. La photodiode 2 est apte à détecter un signal optique qui entre, en alternance, par l'entrée 6 et l'entrée 8. Plus précisément, la photodiode 2 convertit le signal optique en un signal électrique généré entre deux prises de contact 10 et 12 (figures 4 et 5). Typiquement, la longueur d'onde λ du signal optique à détecter est comprise entre 1260 nm et 1625 nm et, de préférence entre 1260 nm et 1360 nm (bande O) ou entre 1530 nm et 1565 nm (bande C). Ici, la longueur d'onde λ est égale à 1310 nm.

La photodiode 2 comporte une dalle 14 en silicium qui s'étend dans un plan horizontal P_{D} appelé « plan de la dalle ». Dans cette demande, les figures sont orientées par rapport à un repère orthogonal XYZ. Les directions X et Y sont horizontales et la direction Y est parallèle à un axe optique 14 le long duquel se propage le signal optique à l'intérieur de la photodiode 2. La direction Z représente la verticale. Dans ce texte, les termes tels que « supérieur », « inférieur », « dessus », « dessous » sont définis par rapport à la direction Z.

Ici, les expressions « éléments réalisés en matériau M », « éléments en matériau M » ou « éléments M » désignent le fait que plus de 95 % et, de préférence, plus de 97 % ou 99 % de la masse de cet élément est constitué par le matériau M.

Dans ce mode de réalisation, la dalle 14 est formée par la couche en silicium monocristallin d'un substrat SOI (« Silicon-On-Insulator»). Par conséquent, elle s'étend directement sur une couche diélectrique 16 elle-même directement déposée sur un substrat 18.

L'épaisseur e₁₄ de la dalle 14 est typiquement supérieure à 50 nm ou 100 nm et généralement inférieure à 1 µm. Ici, l'épaisseur e₁₄ est égale à 300 nm.

La dalle 14 présente une face supérieure horizontale 20 du côté opposé au substrat 18.

La couche 16 est réalisée dans un matériau dont l'indice de réfraction est strictement inférieur à celui du silicium. Par exemple, la couche 16 est réalisée en oxyde de silicium (SiO₂) ou en nitrure de silicium. Le substrat 18 est par exemple en silicium. Son épaisseur est typiquement supérieure à 140 µm ou 500 µm ou 725 µm.

La photodiode 2 comporte deux guides d'onde 22 et 24 ainsi qu'un guide à onde lente 26 en germanium réalisés sur la face supérieure 20. Dans ce mode de réalisation, la photodiode 2 est symétrique par rapport à un plan longitudinal vertical P_{L} contenant l'axe optique 14 et par rapport à un plan médian vertical P_{M} perpendiculaire à l'axe 14. Les guides 22 et 24 sont chacun disposés d'un côté respectif du plan médian P_{M} et seul le guide 22 est décrit plus en détail.

Le guide 22 comporte un ruban 28 rectiligne qui s'étend le long de l'axe 14 depuis l'entrée 6 jusqu'à une sortie 30. Le ruban 28 est conformé pour guider le signal optique reçu sur l'entrée 6 jusqu'à la sortie 30. Ici, il est conformé pour guider un seul mode du signal optique de sorte que le guide d'onde 22 est un guide d'onde monomode. Par exemple, la section transversale du ruban 28 est rectangulaire. Dans ce mode de réalisation, le ruban 28 est en silicium monocristallin. Il ne forme qu'un seul bloc de matière avec la dalle 14.

L'épaisseur e₂₈ du ruban 28 est ici constante. Généralement, l'épaisseur e₂₈ est inférieure ou égale à l'épaisseur e₁₄ de la dalle 14. Par exemple, l'épaisseur e₂₈ est supérieure ou égale à 50 nm ou 100 nm et, de préférence, inférieure à 250 nm ou 500 nm. Ici, l'épaisseur e₂₈ est égale à 150 nm.

Dans ce mode de réalisation, à l'intérieur d'une zone de transition 22E (Figure 2), la section transversale du ruban 28 s'évase, dans la direction X, au fur et à mesure que l'on se rapproche de la sortie 30. Ainsi, la section transversale de la sortie 30 est plus large que la section transversale de l'entrée 6. Une telle zone de transition améliore le couplage optique entre les guides 22 et 26.

Par la suite, lorsque l'on parle de « largeur » du guide 22, on désigne la largeur du ruban 28 mesurée dans la direction X. Plus précisément, par largeur du guide 22, on désigne la distance la plus courte, mesurée dans la direction X, entre des flancs latéraux verticaux du ruban 28. Cette largeur est comprise entre 200 nm et 3 µm. Ici, cette largeur est notée W6 au niveau de l'entrée 6 et W30 au niveau de la sortie 30. Ici, W6 est égale à 0,4 µm et W30 est égale à 0,6 µm. La longueur du guide 22, dans la direction Y, est supérieure à λ.

Le guide 26 comporte des motifs répétés périodiquement dans la direction Y. Ces motifs sont agencés de manière à former un cristal photonique capable de ralentir la propagation du signal optique de longueur d'onde λ qui se propage le long de l'axe 14. Dans ce mode de réalisation, les motifs sont des dents 40 réparties à intervalles réguliers sur des flancs latéraux verticaux d'un ruban central 32 du guide 26. Les dents 40 et le ruban 32 sont décrits plus en détail en référence aux figures 2 à 5.

Le ruban 32 est rectiligne et s'étend le long de l'axe 14 entre deux entrées 34 et 36 disposées chacune d'un côté opposé. Dans ce mode de réalisation, les entrées 34 et 36 sont confondues, respectivement, avec la sortie 30 et la sortie du guide 24.

Ici, la section transversale du ruban 32 est rectangulaire. Sa largeur, notée W32 est typiquement comprise entre 200 nm et 3 µm. Ici, la largeur W32 est égale à la largeur de la section transversale de la sortie 30.

La largeur W32 est définie uniquement entre deux dents 40 immédiatement consécutives. Entre deux dents 40 immédiatement consécutives, la largeur W32 est prise égale à la distance la plus courte, mesurée dans la direction X, entre les flancs latéraux verticaux en vis-à-vis du ruban 32 situés de chaque côté de l'axe 14. Cette largeur W32 est ici constante.

Dans ce mode de réalisation, le ruban 32 comme les dents 40 sont réalisées dans un seul et même bloc de germanium.

La figure 2 représente plus en détail la photodiode 2. Sur cette figure, les pointillés indiquent qu'une portion centrale du guide 26 n'a pas été représentée pour simplifier l'illustration.

Les zone de transition 22E et 24E des guides 22 et 24 sont représentées sur cette figure 2.

Le guide 26 s'étend le long de l'axe 14 sur une longueur L₂₆ supérieure à dₘᵢₙ et, de préférence, supérieure à 2dₘᵢₙ ou 5dₘᵢₙ. dₘᵢₙ est définie par la relation suivante : dₘᵢₙ = Max[À ; 5p], où :
- Max[...] est la fonction qui retourne la plus grande des valeurs listées entre les crochets,
- λ est la longueur d'onde du signal optique, et
- p est le pas entre les dents 40 et sera décrit plus loin.

Typiquement, L₂₆ est supérieure à 1 µm ou 10 µm ou 15 µm et, généralement, inférieure à 1 mm ou 6 mm. Dans la plus part des cas, la longueur L₂₆ est compris entre 1 µm et 50 µm. Ici, la longueur L₂₆ est égale à 15 µm.

Les dents latérales 40 sont disposées de façon périodique dans la direction Y de manière à ralentir la propagation du signal optique dans cette direction. Pour simplifier la figure 2, la référence 40 n'a été indiquée que pour quelques-unes des dents représentées sur cette figure. Un agrandissement d'une telle dent 40 est également visible sur la figure 3.

Chaque dent 40 s'étend, le long d'une direction 41 (figure 3) d'extension depuis une extrémité proximale 42 jusqu'à une extrémité distale 44. Typiquement, la direction 41 est centrée sur la dent 40 et passe par le centre géométrique de cette dent 40. Le centre géométrique d'une dent est le barycentre de tous les points appartenant à cette dent en affectant le même poids à chacun de ces points. Les directions 41 des dents 40 situées du même côté de l'axe 14 sont parallèles entre elles. Ici, la direction 41 est sensiblement parallèle à la direction X. Ainsi, dans ce mode de réalisation, l'angle α entre la direction 41 et l'axe 14 est égal à 90° à plus ou moins 3° près ou plus ou moins 5° près. L'extrémité proximale 42 est ancrée dans les flancs latéraux du ruban 32. Ainsi, le flanc latéral du ruban 32 situé entre deux dents 40 consécutives relie les extrémités proximales 42 de ces deux dents. Pour cela, il s'étend d'une extrémité proximale 42 jusqu'à la suivante dans la direction Y.

Chaque dent 40 ne forme qu'un seul bloc de matière avec le ruban 32.

Chaque dent 40 comporte un point 46 d'intersection respectif entre sa direction 41 d'extension et l'axe 14.

La dent 40 comporte deux flancs latéraux verticaux 50, 52 qui s'étendent chacun depuis l'extrémité proximale 42 jusqu'à l'extrémité distale 44. Ici, ces flancs 50 et 52 sont plats et tous les deux parallèles à la direction X. Dans ce mode de réalisation, l'extrémité distale 44 est également plane. Elle est formée par un plan vertical parallèle à la direction Y. Ainsi, dans ce mode de réalisation, la section horizontale de la dent 40 est rectangulaire.

La largeur W40 des dents 40 dans la direction Y est constante. Par exemple, la largeur W40 est comprise entre p/5 et p/(1,2) et, de préférence, égale à p/2. Ici, le facteur de forme des dents 40 est inférieur à dix et, de préférence, inférieur à 3,5. De préférence, le facteur de forme des dents 40 est compris entre 1,1 et 3,1. Le facteur de forme de la dent 40 est égal au rapport de la longueur sur la largeur du plus petit rectangle horizontal contenant entièrement la dent 40 et son point 46 d'intersection. Ici, le facteur de forme est égal à L₄₀/W40, où L₄₀ est la longueur de la dent 40. La longueur L₄₀ est la distance la plus courte, dans la direction X, entre l'axe 14 et l'extrémité distale 44 de cette dent.

Les dents 40 sont disposées avec un pas p régulier dans la direction Y de part et d'autre de l'axe 14. Le pas p est égal à la distance qui sépare deux points 46 d'intersection immédiatement consécutifs le long de l'axe 14. Le pas p est inférieur à λ/n_{eff} et, de préférence, égale à λ/(2n_{eff})où n_{eff} est l'indice effectif de propagation du mode optique se propageant dans le guide 26. L'indice n_{eff} est aussi connu sous le nom de « constante de phase du mode ». Il est défini par la relation suivante : n_{g} = n_{eff} - λdn_{eff}/dλ, où n_{g} est l'indice de groupe.

Le pas p est généralement supérieur à 50 nm. Dans la plus part des cas, le pas p est compris entre 100 nm et 2 µm. Ici, pour les applications numériques, le pas p est pris égal à 170 nm.

Le facteur de remplissage du guide 26 est défini comme étant égal au rapport S1/S2 où :
- S1 est la surface de la projection orthogonale du guide 26 sur un plan horizontal, c'est-à-dire la surface de la projection orthogonale des parties réalisées en germanium du guide 26, et
- S2 est la surface de la projection orthogonale de la plus petite enveloppe convexe qui contient entièrement la projection orthogonale du guide 26 sur ce même plan horizontal.

Ainsi, plus le facteur de remplissage est faible, plus la surface de germanium à l'intérieur du guide 26 est faible. Typiquement, le facteur de remplissage est compris entre 0,25 et 0,75 ou entre 0,45 et 0,55. Ici, le facteur de remplissage est choisi égal à 0,5.

La figure 4 représente une coupe verticale, parallèle au plan XZ, qui coupe le guide 26 entre deux dents 40. Ainsi, sur cette figure, seul le ruban 32 du guide 26 est visible. Le guide 26 est logé à l'intérieur d'une cavité 60 creusée dans la dalle 14. La cavité 60 comporte un fond horizontal 62 et des bords verticaux 64 réalisés à l'intérieur de la dalle 14.

En pratique, à cause d'imperfections dans le procédé de fabrication de la photodiode 2, les bords verticaux et les flancs verticaux ne sont pas parfaitement verticaux. Par exemple, l'angle entre les bords ou flancs verticaux et l'horizontale est compris entre 80° et 100°. Sur les figures, ces imperfections n'ont pas été représentées.

La profondeur P₆₀ de la cavité 60 est strictement inférieure à l'épaisseur e₁₄ de la dalle 14. Par exemple, l'écart entre l'épaisseur e₁₄ et la profondeur P₆₀ est supérieur ou égal à 20 nm ou 30 nm de sorte qu'il subsiste une fine couche de silicium sous la cavité 60. Ici, l'écart entre l'épaisseur e₁₄ et la profondeur P₆₀ est égale à 50 nm. Pour les simulations numériques, la profondeur P₆₀ est choisie égale à 250 nm.

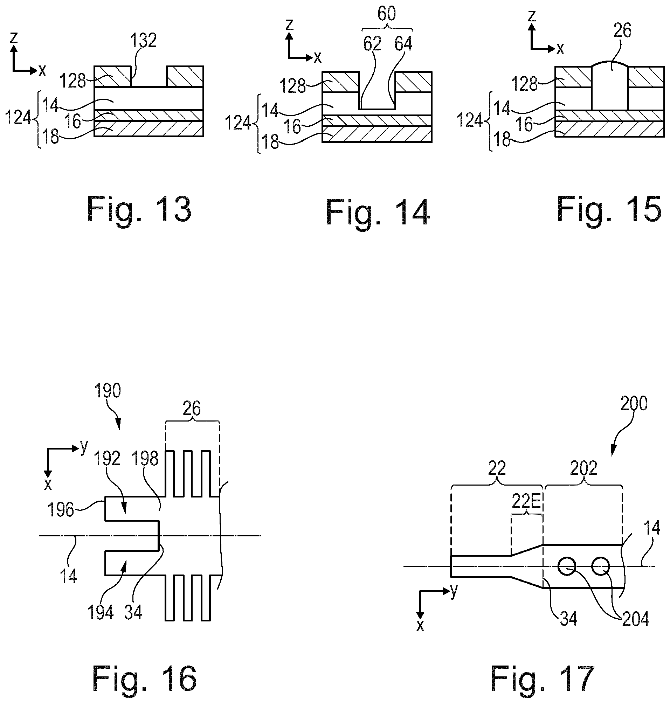

La section horizontale de la cavité 60 est identique à la section horizontale du guide 26 décrite en référence aux figures 2 et 3. On rappelle ici que la « section horizontale » du guide 26 comprend uniquement les emplacements du guide 26 réalisés en germanium. Ainsi, tout évidement réalisé à l'intérieur du guide 26 ne fait pas parti de la section horizontale du guide 26 et cela même si cet évidement est rempli d'un autre matériau que du germanium. Par exemple, comme décrit plus loin en référence à la figure 17, un tel évidement peut être un trou cylindrique vertical traversant de part en part le guide d'onde en germanium et rempli de silicium pour former un plot en silicium au milieu du guide en germanium.

Le guide 26 s'étend verticalement depuis une face horizontale inférieure 66 jusqu'à une face supérieure 68 du côté opposé. Les faces 66 et 68 sont reliées l'une à l'autre par des flancs latéraux verticaux 70 du guide 26. La face 66 est plane et repose directement sur le fond 62 de la cavité 60.

L'épaisseur e₂₆ du guide 26 correspond à la distance la plus courte entre les faces 66 et 68. Ici, l'épaisseur e₂₆, en tous points du guide 26, est strictement supérieure à la profondeur P₆₀ de sorte que la face 68 est située au-dessus de la face 20 de la dalle 14. Par exemple, l'épaisseur e₂₆ est telle que la relation suivante soit vérifiée : e₂₆ ≥ P₆₀ + e₂₂. Généralement, l'épaisseur e₂₆ est inférieure à 2P₆₀. De préférence, l'épaisseur e₂₆ est égale à P₆₀ + e₂₂ à plus ou moins 10 nm près ou plus ou moins 20 nm près.

La partie inférieure des flancs verticaux 70 repose directement sur les bords verticaux 64 en vis-à-vis de la cavité 60. La partie supérieure des flancs verticaux 70 fait saillie au-delà de la face 20 de la dalle 14.

Pour obtenir un courant à partir des charges électriques générées par le signal optique lorsqu'il interagit avec le germanium, le guide 26 est agencé pour former une diode PiN (« Positive intrinsic Negative »). À cet effet, dans la direction X, le guide 26 comporte trois régions contiguës de dopages différents, à savoir :
- une région 72 dopée P,
- une région intrinsèque 74 (« intrinsic région » en anglais), et
- une région 76 dopée N.

Ici, la région 74 s'étend le long de l'axe 14 et les régions 72 et 76 sont situées de part et d'autre du plan longitudinal P_{L}. Les régions 72 et 76 comportent chacune des flancs verticaux 70 respectifs.

Pour qu'un courant puisse traverser la photodiode 2, la région 72 est électriquement raccordée à la prise 10 par l'intermédiaire d'une région 80 dopée P réalisée à l'intérieur de la dalle 14. Plus précisément, la région 80 s'étend du bord vertical 64 de la cavité 60, directement en contact avec le flanc vertical 70 de la région 72, jusqu'à une extrémité inférieure de la prise 10. La région 76 est électriquement raccordée à la prise 12 par l'intermédiaire d'une région 82 dopée N réalisée dans la dalle 14. La région 82 s'étend d'un bord vertical 64 de la cavité 60, directement en contact avec un flanc vertical 70 de la région 76, jusqu'à l'extrémité inférieure de la prise 12.

La partie supérieure du guide 26 qui fait saillie au-dessus de la face 20 de la dalle 4 est encapsulée dans un matériau diélectrique 84. Le matériau 84 a un indice de réfraction inférieur à celui du silicium et du germanium. Typiquement, le matériau 84 est du SiO₂ ou du SiN. Les prises 10 et 12 traversent verticalement ce matériau 84 pour atteindre, respectivement, les régions 80 et 82.

La figure 5 représente en coupe verticale, parallèlement au plan XZ, le guide 26 au niveau d'une paire de dents 40.

La figure 6 représente l'évolution du coefficient de transmission T(λ), exprimé en décibels (dB), de la photodiode 2 en fonction de la longueur d'onde λ du signal optique qui la traverse dans un sens allant de l'entrée 6 vers l'entrée 8. Le coefficient T(λ) est égal au rapport :
- de la puissance du signal optique au niveau de l'entrée 8, sur
- la puissance du signal optique au niveau de l'entrée 6.

Les courbes 90 à 95 ont été obtenues par simulation numérique et, plus précisément, par la méthode FDTD-3D (« Finite-Difference Time-Domain 3 Dimensions »).

Les courbes 91 à 95 ont été obtenues en simulant la photodiode 2 pour différentes longueurs L₄₀ des dents 40 comprises entre 0,45 µm et 1,24 µm. La courbe 90 est une courbe de référence correspondant à un cas où le guide 26 est dépourvu de dent (L₄₀ = W32/2). On rappelle ici que la largeur W32 du ruban 32 est de 0,6 µm de sorte que la longueur L₄₀, telle que définie précédemment, doit être supérieure à 0,3 µm pour que la dent 40 fasse saillie au-delà des flancs verticaux 70 du ruban 32.

Ici, les courbes 90 à 95 correspondent, respectivement, aux longueurs L₄₀ suivantes : 0,45 µm ; 0,6 µm ; 0,77 µm ; 0,92 µm ; 1,08 µm et 1,24 µm.

Ce graphe montre que même pour une longueur L₄₀ faible, le taux T(λ) présente un minimum inférieur à 25 dB pour une longueur d'onde λ d'environ 1,3 µm. Par conséquent, même dans ce cas, la majorité du signal optique entrant est absorbée par le guide 26. La photodiode 2 présente donc un taux d'absorption supérieur à 1,5 dB/µm.

De plus, ce graphe montre aussi que la longueur L₄₀ peut être ajustée expérimentalement ou par simulation numérique pour atteindre des taux T(λ) de transmission encore plus faibles. Par exemple, ici, pour une longueur L₄₀ égale à 0,92 µm (courbe 93), il est possible d'obtenir un taux T(λ) inférieur à 40 dB et donc un taux d'absorption encore plus élevé. Enfin, il est aussi possible d'adapter la longueur L₄₀ pour élargir la bande interdite du guide 26. Par exemple, ici, une longueur L₄₀ égale à 1,24 µm (courbe 95) permet d'obtenir une bande interdite beaucoup plus large qu'avec une longueur L₄₀ égale à 0,92 µm.

La figure 7 représente un dispositif 100 incorporant la photodiode 2 pour détecter un signal optique circulant dans un guide d'onde 102 dans un sens A et, en alternance, dans un sens opposé B. Dans ce mode de réalisation, le dispositif 100 comporte un anneau résonant 104 couplé optiquement au guide 102, par exemple, par un couplage évanescent. Cet anneau 104 comporte :
- une portion 106 qui s'étend à proximité du guide 102 est qui est couplée optiquement à ce guide par le couplage évanescent,
- la photodiode 2,
- une portion recourbée 108 qui raccorde optiquement une extrémité 106G de la portion 106 à l'entrée 6 de la photodiode 2, et
- une autre portion recourbée 110 qui raccorde optiquement une extrémité 106D de la portion 106 à l'entrée 8 de la photodiode 2.

Lorsqu'un signal optique se propage dans le sens A, une fraction de ce signal optique est transmise à l'anneau 104 par l'intermédiaire du couplage évanescent. Cette fraction de signal optique se propage alors à l'intérieure des portions 106 et 110 jusqu'à l'entrée 8. Ensuite, cette fraction du signal optique est détectée par la photodiode 2. Comme indiqué précédemment, cette fraction du signal optique est pratiquement totalement absorbée par le guide 26 de sorte que la puissance de cette fraction de signal optique restituée sur l'entrée 6 est infime. Ainsi, cela ne perturbe pas le signal optique qui circule dans le guide 102.

Lorsque le signal optique se propage dans le guide 102 dans le sens B, le fonctionnement du dispositif 100 est le même sauf que la fraction du signal optique à détecter est reçue sur l'entrée 6 et non pas sur l'entrée 8 de la photodiode 2. La même photodiode 2 permet donc de détecter deux signaux optiques différents.

La fabrication de la photodiode 2 va maintenant être décrite à l'aide de l'organigramme de la figure 8 et en référence aux figures 9 à 15.

Le procédé débute par une étape 118 de fourniture d'un substrat SOI 124 (Figure 9) correspondant à l'empilement du substrat 18, de la couche 16 et de la dalle 14.

Ensuite, lors d'une étape 120, les guides 22 et 24 sont fabriqués. La fabrication d'un guide d'onde en forme de « rib » tels que les guides 22 et 24 est bien connue. Ainsi, cette étape n'est pas décrite en détail. Par exemple, les rubans 28 des guides 22, 24 sont fabriquées par gravure et amincissement de l'épaisseur de la dalle 14.

Lors d'une étape 126, une couche 128 de protection (Figure 10) est déposée sur la face supérieure 20 de la dalle 14. Cette couche 128 est réalisée dans un matériau sur lequel le germanium ne peut pas croître lors d'une opération de croissance du germanium par épitaxie en phase vapeur. Par exemple, la couche 128 est réalisée en dioxyde de silicium. Son épaisseur est typiquement supérieure ou égale à 50 nm et généralement inférieure à 1 µm.

Ensuite, lors d'une étape 130, une cavité 132 (Figure 12) ayant la même section horizontale que le guide 26 est creusée dans la couche 128 à l'emplacement où doit être réalisée la cavité 60. Par exemple, la cavité 132 est réalisée par photolithographie. À cet effet, lors d'une opération 134, une couche 136 (Figure 11) de résine photosensible est déposée sur la face supérieure de la couche 128. Puis un évidement 138 (Figure 11) qui traverse de part en part l'épaisseur de la couche 136 de résine est réalisé pour mettre à nu la portion de la face supérieure de la couche 128 à graver. La section horizontale de l'évidement 138 est identique à la section horizontale du guide 26.

Ensuite, lors d'une opération 142, la couche 128 est gravée à travers l'évidement 138 pour obtenir la cavité 132.

Lors d'une étape 144 (figure 13), la couche 136 de résine est retirée pour mettre à nu la face supérieure de la couche 128 dans laquelle la cavité 132 a été réalisée.

Lors d'une étape 148, la cavité 132 (figure 14) est prolongée, dans la direction verticale, à l'intérieur de la dalle 14 pour réaliser la cavité 60 dans cette dalle 14. Lors de cette étape 148, la couche 128 est donc utilisée comme un masque, c'est-à-dire que la dalle 14 est gravée à travers la cavité 132. La gravure de la dalle 14 est interrompue avant d'atteindre la couche 16 pour qu'il subsiste une fine couche de silicium d'au moins 30 nm d'épaisseur entre le fond 62 de la cavité 60 et la couche 16.

Lors d'une étape 150 (figure 15), on exécute l'opération de croissance épitaxiale en phase vapeur de germanium sur le fond 62 de la cavité 60 jusqu'à remplir complètement cette cavité 60. Typiquement, cette opération est réalisée en mettant en oeuvre une méthode connue sous l'acronyme RP-CVD (« Reduced Pressure Chemical Vapor Déposition »). Pour cela, une faible épaisseur de germanium est d'abord déposée sous faible température directement sur le fond 62. Par exemple, par faible température, on désigne une température inférieure à 400 °C. Lors de cette première phase, la température est également généralement supérieure à 200 °C. Par faible épaisseur, on désigne une épaisseur inférieure à 50 nm et généralement supérieure ou égale à 30 nm. Ici, lors de la première phase, l'épaisseur de germanium déposée sur le fond 62 est de 40 nm.

Ensuite, on procède à une deuxième phase de croissance sous température plus élevée de la couche de germanium à l'intérieur de la cavité 60. Typiquement, lors de la deuxième phase, la température est supérieure à 650 °C ou 700 °C. Ici, elle est de 730 °C. Cette deuxième phase est utilisée pour déposer 410 nm de germanium à l'intérieur de la cavité 60 et donc complètement remplir cette cavité. À ce stade, l'épaisseur de germanium est égale à l'épaisseur e₂₆ souhaitée.

Un tel procédé est par exemple décrit dans l'article suivant : Vivien L. et Al : « 42 GHz p.i.n Germanium photodetector integrated in a silicon-on-insulator waveguide », Optics Express, Vol. 17, N°8, 13/4/2009, pages 6252-6257. Par la suite cet article est désigné par le terme « Vivien2009 ». Ce procédé n'est donc pas décrit ici plus en détail.

Lors de l'étape 150, l'épaisseur e₂₆ de germanium déposée reste inférieure à l'épaisseur critique au-delà de laquelle le nombre de défauts de dislocation du germanium devient très important. De plus, typiquement, l'épaisseur e₂₆ est ajustée pour que la face supérieure 68 du guide 26 soit, en tout point, située à une altitude inférieure à 500 nm et, de préférence, inférieure à 200 nm ou 100 nm au-dessus du plan horizontal contenant la face 20 de la dalle 14.

Lors de l'étape 150, le germanium croît uniquement à l'intérieur de la cavité 60 et non pas sur la couche 128. Ainsi, en même temps que le germanium est déposé sur la dalle 14, les dents 40 sont formées car la section transversale de la cavité 60 est identique à celle souhaitée pour le guide d'onde 26.

Lors d'une étape 152, la couche 128 est retirée et l'on procède alors au dopage localisé du germanium 26 et de la dalle 14 pour obtenir les régions dopées 72, 76, 80 et 82. Ce dopage est nécessaire pour récupérer le photo-courant.

Lors d'une étape 154, le guide 26 est encapsulé dans la couche 84.

La figure 16 représente une partie gauche d'une photodiode 190. Les autres parties de la photodiode 190 se déduisent par symétrie par rapport au plan médian P_{M}. La photodiode 190 est identique à la photodiode 2 sauf que le guide 22 est remplacé par deux guides d'onde 192 et 194. Ici, le guide 194 est le symétrique du guide 192 par rapport au plan longitudinal P_{L}. Le guide 192 comporte une entrée 196 et une sortie 198. Le guide 192 est par exemple construit de façon similaire ou identique à ce qui a été décrit pour le guide 22 sauf qu'il est dépourvu de zone de transition. La sortie 198 est en contact direct avec l'entrée 34 du guide 26.

Dans ce mode de réalisation, la photodiode 190 comporte plusieurs entrées raccordées à la même entrée 34 du guide 26. Ce mode de réalisation permet d'augmenter encore plus le nombre d'entrées de la photodiode et donc de limiter encore plus le nombre de photodiodes à utiliser pour détecter des signaux optiques qui se propagent, en alternance, dans plusieurs guides d'onde différents.

La figure 17 représente une partie gauche d'une photodiode 200. Les autres parties de la photodiode 200 se déduisent par symétrie par rapport au plan P_{M}.

La photodiode 200 est identique à la photodiode 2 sauf que le guide 26 est remplacé par un guide à onde lente 202. Le guide 202 est identique au guide 26 sauf que les dents 40 sont remplacées par des plots 204. Ces plots sont issus de la dalle 14 par une protection avant gravure de la cavité 60. Le guide 200 est similaire à celui décrit en référence à la figure 1 de la demande US9035409B2 et seuls quelques détails sont donnés ici.

Les plots 204 sont répétés, avec le pas p le long de l'axe 14. Chaque plot 204 est un cylindre vertical dont la section transversale est par exemple circulaire. Il s'étendant depuis le fond 62 de la cavité 60 jusqu'à la face supérieure 68 du guide à onde lente. Par exemple, la partie inférieure de chaque plot qui est situé à l'intérieur de la cavité 60 est réalisée en silicium monocristallin. La partie inférieure de chaque plot 204 ne forme qu'un seul bloc de matière avec la dalle 14. La partie supérieure du plot 204 qui dépasse au-dessus de la face 20 est par exemple réalisée en oxyde de silicium. Avec ce choix des matériaux pour le plot 204, la photodiode 200 est fabriquée avec le même procédé que celui de la figure.

### Variante du guide à onde lente.

Ce qui a été décrit ci-dessus s'applique aussi au cas où la photodiode est une diode PN (Positive Negative). Dans ce dernier cas, la région intrinsèque 74 est omise.

Dans une autre variante, en tout point du guide 26, l'épaisseur e₂₆ est égale à la profondeur P₆₀. Dans ce cas, la face supérieure 68 du guide 26 affleure la face supérieure 20 de la dalle 14.

Une fine couche d'oxyde de silicium inférieure à 5 nm d'épaisseur peut exister entre les bords verticaux de la cavité 60 et les flancs verticaux 70 du guide à onde lente.

Dans une autre mode de réalisation, les régions dopées 72, 76 sont omises. Dans ce mode de réalisation, le dopage est alors uniquement réalisé dans la dalle 14 et seuls les régions 80 et 82 sont dopées. Un tel dopage peut alors aussi être réalisé dans le substrat SOI 124, avant l'étape 118, par des implantations localisées d'ions (Bore/Phosphore par exemple). Dès lors, l'étape 152 peut aussi être omise.

Le guide à onde lente n'est pas nécessairement symétrique par rapport au plan médian P_{M}. Par exemple, la zone de transition 22E peut être plus courte ou plus longue que la zone 24E.

En variante, l'angle entre la direction 41 d'extension des dents 40 et l'axe 14 est différent de 90°. Par exemple, cet angle est compris entre 30° et 150° ou entre 45° et 135°. Ainsi, dans ces modes de réalisation, les dents sont inclinées soit vers l'avant soit vers l'arrière par rapport à la direction de propagation du signal optique.

Les dents 40 peuvent avoir d'autres formes. En particulier, il n'est pas nécessaire que la section horizontale de ces dents soit rectangulaire. Par exemple, la section horizontale de la dent 40 peut aussi être triangulaire, carrée, circulaire ou autres. La dent 40 peut aussi avoir une section horizontale identique à celle représentée dans l'un des articles suivants :
- A. Brimont et al, « High speed silicon electro-optical modulators enhanced via slow light propagation », Optics express 20876, 14/14/2011, Vol 19, no 21 ;
- Shayan Mookherjea et al, « Localisation in silicon nanophotonic slow - light waveguides », Nature photonics, vol 2, 02/2008.

La longueur L₄₀ peut être supérieure à 2λ. Toutefois, dans ce cas, la partie de la dent 40 qui s'étend au-delà de 2λ a très peu d'influence sur le fonctionnement du guide à onde lente. Dès lors, lorsque la longueur L₄₀ est supérieure à 2λ, la longueur des dents 40 peut être quelconque à partir du moment où elle reste supérieure à 2λ. En particulier, dans ce cas, il n'est pas nécessaire que toutes les dents 40 du guide 26 aient la même longueur. De même, dans ce cas, les dents 40 dont les longueurs sont supérieures à 2λ n'ont pas besoin d'être symétriques, par rapport au plan P_{L}.

La largeur du ruban 32 du guide 26 n'est pas nécessairement constante. Par exemple, cette largeur peut varier progressivement jusqu'à un minimum situé à équidistance des deux entrées.

En variante, le même guide à onde lente est utilisé pour ralentir simultanément plusieurs signaux optiques ayant des longueurs d'onde différentes. Par exemple, dans ce cas, chaque longueur d'onde différente correspond à un point de fonctionnement respectif du guide à onde lente.

### Variante des guides d'onde en silicium :

Le guide d'onde en silicium peut être remplacé par un guide d'onde en silicium multimode.

Dans un autre mode de réalisation, le ruban 28 en silicium est séparé de la dalle en silicium par une fine couche d'un autre matériau comme par exemple, une couche d'oxyde de silicium. Dans une autre variante, le ruban 28 est réalisé dans un matériau différent du matériau de la dalle 14, comme cela est décrit dans la demande US8761220. Par exemple, le ruban est réalisé en silicium polycristallin.

Dans une autre variante, le guide d'onde 24 est omis de sorte que la photodiode ne comporte plus qu'une seule entrée.

En variante, la zone de transition entre les guides 22 et 26 est omise. Par exemple, la section transversale du guide 22 est constante depuis l'entrée 6 jusqu'à la sortie 30.

Dans un autre mode de réalisation, les guides 22 et 24 sont différents. Par exemple, ils sont conformés pour guider des signaux optiques différents.

### Autres variantes :

L'oxyde de silicium utilisé pour encapsuler le guide 26 et les guides 22 et 24 peut être remplacé par un autre matériau comme du nitrure de silicium.

Enfin, les photodiodes décrites précédemment, et en particulier les photodiodes à deux entrées en vis-à-vis, peuvent aussi être fabriquées par d'autres procédés que le procédé de la figure 8. Par exemple, en variante, la couche 128 est omise lors du procédé de fabrication. Dans ce cas, lors de l'étape de croissance du germanium, la couche de germanium croit également non seulement à l'intérieur de la cavité 60 mais aussi sur la totalité de la face 20 de la dalle 14 en silicium. Ensuite, une étape de polissage, par exemple un polissage mécanico-chimique ou CMP (Chemical Mecanical Polissing) est mise en oeuvre pour éliminer l'épaisseur de germanium présent sur la face supérieure 60 de la dalle 14 sans pour autant retirer l'épaisseur de germanium logé à l'intérieur de la cavité. En procédant ainsi, on obtient un guide à onde lente identique au guide 26 sauf que l'épaisseur e₂₆ de ce guide est égale à la profondeur P₆₀ de la cavité 60. Les autres étapes de fabrication de la photodiode sont, par exemple, identiques à celles précédemment décrites.

Un autre procédé possible de fabrication des photodiodes décrites, consiste à remplacer la couche 128 de protection par une une couche d'arrêt identique mais réalisée dans un matériau sur lequel le germanium peut croître par épitaxie lors de l'étape (150). Ensuite, la couche de germanium qui a crû sur cette couche d'arrêt est retirée par polissage, par exemple par un polissage CMP, en utilisant cette couche d'arrêt comme couche d'arrêt de ce polissage. Puis, la couche d'arrêt est elle-même retirée ou non.

## Revendications

1. Procédé de fabrication d'un guide (26 ; 202) à onde lente en germanium sur une dalle en silicium s'étendant principalement dans un plan appelé « plan de la dalle », ce guide à onde lente comportant une section horizontale, parallèle au plan de la dalle, qui présente un même motif répété avec un pas régulier le long d'un axe optique, ces motifs étant disposés de façon symétrique de part et d'autre de l'axe optique de manière à ce que cet agencement de motifs ralentisse la propagation du signal optique le long de l'axe optique à l'intérieur du guide (26 ; 202) à onde lente, ce motif comportant deux dents latérales (40) disposées chacune d'un côté respectif d'un ruban central (32) en germanium ou un plot cylindrique (204) en silicium qui traverse de part en part un ruban central en germanium,
**caractérisé en ce que** le procédé comporte :
- la réalisation (148) dans la dalle en silicium d'une cavité (60) dont la section, parallèle au plan de la dalle, est identique à la section horizontale du guide (26 ; 202) à onde lente et dont le fond (62) est situé à l'intérieur de la dalle en silicium, puis
- l'exécution (150) d'une opération de croissance épitaxiale en phase vapeur du germanium sur le fond de la cavité (60) jusqu'à remplir complètement cette cavité de germanium, le germanium étant ainsi déposé sur la dalle en silicium et, en même temps, structuré pour former les motifs du guide à onde lente, et
- avant la mise en oeuvre de ladite opération de croissance épitaxiale, le dépôt (126) d'une couche (128) de protection sur une face supérieure de la dalle en silicium qui entoure la cavité (60), cette couche (128) de protection étant réalisée dans un matériau sur lequel le germanium ne peut pas croître lors de ladite opération de croissance épitaxiale, ou, après la mise en oeuvre de ladite opération de croissance épitaxiale, le retrait du germanium qui a crû sur cette face supérieure de la dalle en silicium qui entoure la cavité.

2. Procédé de fabrication d'une photodiode (2 ; 190 ; 200) sur une dalle en silicium s'étendant principalement dans un plan appelé « plan de la dalle », ce procédé comportant :
- la réalisation (120) sur la dalle en silicium d'un premier guide d'onde (22 ; 192, 194) comportant un ruban (28) apte à guider un signal optique depuis une entrée (6) jusqu'à une sortie (30),
- la réalisation sur la dalle en silicium d'un guide (26 ; 202) à onde lente en germanium s'étendant le long d'un axe optique à partir d'une entrée (34) couplée optiquement à la sortie (30) du premier guide d'onde, ce guide à onde lente comportant :
• une section horizontale, parallèle au plan de la dalle, qui présente un même motif répété avec un pas régulier le long d'un axe optique, ces motifs étant disposés de façon symétrique de part et d'autre de l'axe optique de manière à ce que cet agencement de motifs ralentisse la propagation d'un signal optique le long de l'axe optique à l'intérieur du guide à onde lente, ce motif comportant deux dents latérales (40) disposées chacune d'un côté respectif d'un ruban central (32) en germanium ou un plot cylindrique (204) en silicium qui traverse de part en part un ruban central en germanium, et
• deux régions dopées (72, 76) de signes opposés, disposées de part et d'autre de l'axe optique pour capter les porteurs de charges générés par le signal optique qui se propage dans ce guide à onde lente,
**caractérisé en ce que** le guide (26 ; 202) à onde lente est fabriqué en mettant en oeuvre le procédé conforme à la revendication 1.

3. Photodiode fabriquée par un procédé conforme à la revendication 2, cette photodiode comportant :
- une dalle (14) en silicium s'étendant principalement dans un plan appelé « plan de la dalle »,
- un premier guide d'onde (22 ; 192, 194) comportant un ruban apte à guider un signal optique depuis une entrée, destinée à recevoir un signal optique à détecter, jusqu'à une sortie, ce ruban étant formé sur la dalle,
- un guide (26 ; 202) à onde lente en germanium s'étendant le long d'un axe optique à partir d'une première entrée, couplée optiquement à la sortie du premier guide d'onde, ce guide à onde lente comportant :
• deux régions (72, 76) dopées de signes opposés disposées de part et d'autre de l'axe optique pour capter les porteurs de charges générés par le signal optique qui se propage dans ce guide à onde lente, et
• une section horizontale, parallèle au plan de la dalle, qui présente des motifs (40 ; 204) disposés de façon symétrique de part et d'autre de l'axe optique et répétés avec un pas régulier p le long de cet axe optique de manière à ralentir la propagation du signal optique dans le guide à onde lente, ce motif comportant deux dents latérales disposées chacune d'un côté respectif d'un ruban central en germanium ou un plot cylindrique en silicium qui traverse de part en part un ruban central en germanium,
**caractérisée en ce que** :
- la photodiode comporte une cavité (60), creusée dans la dalle en silicium, dont le fond (62) est situé à l'intérieur de la dalle en silicium et dont la section, parallèle au plan de la dalle, est identique à la section horizontale du guide à onde lente, et
- le guide à onde lente remplit complètement cette cavité et s'étend, dans une direction perpendiculaire au plan de la dalle, depuis le fond (62) de cette cavité jusqu'à une face supérieure située au même niveau ou au-dessus de la face supérieure de la dalle.

4. Photodiode selon la revendication 3, dans laquelle la photodiode comporte également :
- un deuxième guide d'onde (24) comportant un ruban apte à guider un signal optique depuis une autre entrée (8), destinée à recevoir un autre signal optique à détecter, jusqu'à une autre sortie, ce ruban étant formé sur la dalle, et
- le guide à onde lente comporte, le long de l'axe optique et du côté opposé à la première entrée (34), une deuxième entrée (36) optiquement couplée à la sortie du deuxième guide d'onde.

5. Photodiode selon l'une quelconque des revendications 3 à 4, dans laquelle :
- le guide (26) à onde lente comporte le ruban central (32) qui s'étend le long de l'axe optique pour guider le signal optique le long de cet axe optique, et
- le motif comporte les deux dents latérales (40) disposées chacune d'un côté respectif du ruban central et symétriques l'une de l'autre par rapport à un plan longitudinal, ce plan longitudinal étant perpendiculaire au plan de la dalle et contenant l'axe optique, la longueur de chacune de ces dents étant supérieure ou égale à la largeur du ruban central, la longueur d'une dent étant égale à la distance la plus courte entre son extrémité distale (44) et le plan longitudinal et la largeur du ruban central étant égale à la distance la plus courte entre deux flancs verticaux (70) en vis-à-vis de ce ruban central situés chacun d'un côté respectif de l'axe optique et entre deux dents successives.

6. Photodiode selon la revendication 5, dans laquelle la longueur de plus d'un tiers des dents est deux fois supérieure ou égale à la largeur du ruban central.

7. Photodiode selon l'une quelconque des revendications 3 à 6, dans laquelle la dalle comporte des régions dopées (80, 82) de signes opposés directement en contact avec le guide à onde lente, ces régions dopées de la dalle comportant des bords dopés verticaux (64) de la cavité directement en contact mécanique et électrique avec des flancs verticaux (70) du guide à onde lente.

8. Photodiode selon l'une quelconque des revendications 3 à 7, dans laquelle la sortie (30) du premier guide d'onde est en vis-à-vis et directement en contact mécanique avec la première entrée (34) du guide à onde lente.

9. Photodiode selon l'une quelconque des revendications 3 à 8, dans laquelle l'épaisseur du guide à onde lente est égale à la profondeur de la cavité (60).

10. Photodiode selon l'une quelconque des revendications 3 à 9, dans lequel la dalle (14) en silicium s'étend directement sur une couche diélectrique (16) elle-même directement déposée sur un substrat (18).

## Patentansprüche

1. Verfahren zur Herstellung eines Verzögerungswellenleiters (26; 202) aus Germanium auf einer Siliciumplatte, die sich hauptsächlich in einer Ebene erstreckt, die als "Ebene der Platte" bezeichnet wird, wobei der Verzögerungswellenleiter einen horizontalen Abschnitt, parallel zur Ebene der Platte, umfasst, der dasselbe in einem regelmäßigen Abstand wiederholte Muster entlang einer optischen Achse aufweist, wobei die Muster symmetrisch auf beiden Seiten der optischen Achse angeordnet sind, damit die Anordnung von Mustern die Ausbreitung des optischen Signals entlang der optischen Achse im Inneren des Verzögerungswellenleiters (26; 202) verlangsamt, wobei das Muster zwei laterale Zähne (40) umfasst, die jeweils auf einer jeweiligen Seite eines zentralen Bands (32) aus Germanium oder einer zylindrischen Kontaktstelle (204) aus Silicium angeordnet sind, die von einer Seite zur anderen ein zentrales Band aus Germanium durchquert,
**dadurch gekennzeichnet, dass** das Verfahren umfasst:
- die Herstellung (148), in der Siliciumplatte, eines Hohlraums (60), dessen Abschnitt, parallel zur Ebene der Platte, mit dem horizontalen Abschnitt des Verzögerungswellenleiters (26; 202) identisch ist, und dessen Boden (62) im Inneren der Siliciumplatte angeordnet ist, dann
- die Ausführung (150) eines Vorgangs eines epitaxialen Wachstums in der Dampfphase von Germanium auf dem Boden des Hohlraums (60), bis der Hohlraum vollständig mit Germanium gefüllt ist, wobei das Germanium so auf der Siliciumplatte abgeschieden und gleichzeitig strukturiert wird, um die Muster des Verzögerungswellenleiters zu bilden, und
- vor der Durchführung des Vorgangs des epitaxialen Wachstums, die Abscheidung (126) einer Schutzschicht (128) auf einer oberen Fläche der Siliciumplatte, die den Hohlraum (60) umgibt, wobei die Schutzschicht (128) aus einem Material hergestellt ist, auf dem das Germanium während des Vorgangs des epitaxialen Wachstums nicht wachsen kann, oder, nach der Durchführung des Vorgangs des epitaxialen Wachstums, die Entfernung des Germaniums, das auf der oberen Fläche der Siliciumplatte gewachsen ist, die den Hohlraum umgibt.

2. Verfahren zur Herstellung einer Photodiode (2; 190; 200) auf einer Siliciumplatte, die sich hauptsächlich in einer Ebene erstreckt, die als "Ebene der Platte" bezeichnet wird, wobei das Verfahren umfasst:
- die Herstellung (120), auf der Siliciumplatte, eines ersten Wellenleiters (22; 192; 194), der ein Band (28) umfasst, das geeignet ist, ein optisches Signal von einem Eingang (6) bis zu einem Ausgang (30) zu führen,
- die Herstellung, auf der Siliciumplatte, eines Verzögerungswellenleiters (26; 202) aus Germanium, welcher sich entlang einer optischen Achse von einem Eingang (34) erstreckt, der optisch mit dem Ausgang (30) des ersten Wellenleiters gekoppelt ist, wobei der Verzögerungswellenleiter umfasst:
▪ einen horizontalen Abschnitt, parallel zur Ebene der Platte, der dasselbe in einem regelmäßigen Abstand wiederholte Muster entlang einer optischen Achse aufweist, wobei die Muster symmetrisch auf beiden Seiten der optischen Achse angeordnet sind, damit die Anordnung von Mustern die Ausbreitung eines optischen Signals entlang der optischen Achse im Inneren des Verzögerungswellenleiters verlangsamt, wobei das Muster zwei laterale Zähne (40) umfasst, die jeweils auf einer jeweiligen Seite eines zentralen Bands (32) aus Germanium oder einer zylindrischen Kontaktstelle (204) aus Silicium angeordnet sind, die von einer Seite zur anderen ein zentrales Band aus Germanium durchquert, und
▪ zwei dotierte Gebiete (72, 76) mit entgegengesetzten Vorzeichen, die auf beiden Seiten der optischen Achse angeordnet sind, um die Ladungsträger einzufangen, die von dem optischen Signal generiert werden, das sich in dem Verzögerungswellenleiter ausbreitet,
**dadurch gekennzeichnet, dass** der Verzögerungswellenleiter (26; 202) hergestellt wird, indem das Verfahren nach Anspruch 1 durchgeführt wird.

3. Photodiode, welche durch ein Verfahren nach Anspruch 2 hergestellt ist, wobei die Photodiode umfasst:
- eine Siliciumplatte (14), die sich hauptsächlich in einer Ebene erstreckt, die als "Ebene der Platte" bezeichnet wird,
- einen ersten Wellenleiter (22; 192; 194), der ein Band umfasst, das geeignet ist, ein optisches Signal von einem Eingang, der dazu bestimmt ist, ein zu detektierendes optisches Signal zu empfangen, bis zu einem Ausgang zu führen, wobei das Band auf der Platte gebildet ist,
- einen Verzögerungswellenleiter (26; 202) aus Germanium, welcher sich entlang einer optischen Achse von einem ersten Eingang erstreckt, der optisch mit dem Ausgang des ersten Wellenleiters gekoppelt ist, wobei der Verzögerungswellenleiter umfasst:
▪ zwei dotierte Gebiete (72, 76) mit entgegengesetzten Vorzeichen, die auf beiden Seiten der optischen Achse angeordnet sind, um die Ladungsträger einzufangen, die von dem optischen Signal generiert werden, das sich in dem Verzögerungswellenleiter ausbreitet, und
▪ einen horizontalen Abschnitt, parallel zur Ebene der Platte, der Muster (40; 204) aufweist, die symmetrisch auf beiden Seiten der optischen Achse angeordnet sind und in einem regelmäßigen Abstand p entlang der optischen Achse wiederholt sind, um die Ausbreitung des optischen Signals in dem Verzögerungswellenleiter zu verlangsamen, wobei das Muster zwei laterale Zähne umfasst, die jeweils auf einer jeweiligen Seite eines zentralen Bands aus Germanium oder einer zylindrischen Kontaktstelle aus Silicium angeordnet sind, die von einer Seite zur anderen ein zentrales Band aus Germanium durchquert,
**dadurch gekennzeichnet, dass**:
- die Photodiode einen Hohlraum (60) umfasst, der in der Siliciumplatte ausgehöhlt ist, dessen Boden (62) im Inneren der Siliciumplatte angeordnet ist, und dessen Abschnitt, parallel zur Ebene der Platte, mit dem horizontalen Abschnitt des Verzögerungswellenleiters identisch ist, und
- der Verzögerungswellenleiter den Hohlraum vollständig ausfüllt und sich in einer Richtung rechtwinklig zur Ebene der Platte von dem Boden (62) des Hohlraums bis zu einer oberen Fläche erstreckt, die auf derselben Höhe oder über der oberen Fläche der Platte angeordnet ist.

4. Photodiode nach Anspruch 3, wobei die Photodiode auch umfasst:
- einen zweiten Wellenleiter (24), der ein Band umfasst, das geeignet ist, ein optisches Signal von einem anderen Eingang (8), der dazu bestimmt ist, ein anderes zu detektierendes optisches Signal zu empfangen, bis zu einem anderen Ausgang zu führen, wobei das Band auf der Platte gebildet ist, und
- wobei der Verzögerungswellenleiter, entlang der optischen Achse und auf der Seite gegenüber dem ersten Eingang (34), einen zweiten Eingang (36), der optisch mit dem Ausgang des zweiten Wellenleiters gekoppelt ist, umfasst.

5. Photodiode nach einem der Ansprüche 3 bis 4, wobei:
- der Verzögerungswellenleiter (26) das zentrale Band (32) umfasst, das sich entlang der optischen Achse erstreckt, um das optische Signal entlang der optischen Achse zu führen, und
- das Muster zwei laterale Zähne (40) umfasst, die jeweils auf einer jeweiligen Seite des zentralen Bands angeordnet und symmetrisch zueinander in Bezug auf eine longitudinale Ebene sind, wobei die longitudinale Ebene rechtwinklig zu der Ebene der Platte ist und die optische Achse enthält, wobei die Länge jedes der Zähne größer oder gleich der Breite des zentralen Bands ist, wobei die Länge eines Zahns gleich der kürzesten Distanz zwischen seinem distalen Ende (44) und der longitudinalen Ebene ist, und die Breite des zentralen Bands gleich der kürzesten Distanz zwischen zwei vertikalen Flanken (70) gegenüber dem zentralen Band ist, die jeweils auf einer jeweiligen Seite der optischen Achse und zwischen zwei aufeinanderfolgenden Zähnen angeordnet sind.

6. Photodiode nach Anspruch 5, wobei die Länge von mehr als einem Drittel der Zähne zweimal größer als die oder gleich der Breite des zentralen Bands ist.

7. Photodiode nach einem der Ansprüche 3 bis 6, wobei die Platte dotierte Gebiete (80, 82) mit entgegengesetzten Vorzeichen direkt in Kontakt mit dem Verzögerungswellenleiter umfasst, wobei die dotierten Gebiete der Platte vertikale dotierte Ränder (64) des Hohlraums direkt in mechanischem und elektrischen Kontakt mit den vertikalen Flanken (70) des Verzögerungswellenleiters umfassen.

8. Photodiode nach einem der Ansprüche 3 bis 7, wobei der Ausgang (30) des ersten Wellenleiters gegenüber und in direktem mechanischen Kontakt mit dem ersten Eingang (34) des Verzögerungswellenleiters ist.

9. Photodiode nach einem der Ansprüche 3 bis 8, wobei die Dicke des Verzögerungswellenleiters gleich der Tiefe des Hohlraums (60) ist.

10. Photodiode nach einem der Ansprüche 3 bis 9, wobei sich die Platte (14) aus Silicium direkt über einer dielektrischen Schicht (16) erstreckt, die selbst direkt über einem Substrat (18) abgeschieden ist.

## Claims

1. Method for manufacturing a germanium slow light waveguide (26; 202) on a silicon plate extending mainly in a plane referred to as the "plane of the plate", this slow light waveguide including a horizontal cross section, parallel to the plane of the plate, that exhibits the same pattern repeated at regular intervals along an optical axis, these patterns being positioned symmetrically on either side of the optical axis in such a way that this arrangement of patterns slows the propagation of the optical signal along the optical axis inside the slow light waveguide (26; 202), this pattern including two lateral teeth (40) each positioned on a respective side of a germanium central strip (32) or a silicon cylindrical pad (204) that passes from one side of the germanium central strip to the other,
**characterized in that** the method includes:
- producing (148), in the silicon plate, a cavity (60) the cross section of which, parallel to the plane of the plate, is identical to the horizontal cross section of the slow light waveguide (26; 202) and the bottom (62) of which is located inside the silicon plate; then
- carrying out (150) an operation of vapour phase epitaxial growth of germanium on the bottom of the cavity (60) until this cavity is completely filled with germanium, the germanium thus being deposited on the silicon plate and, simultaneously, structured so as to form the patterns of the slow light waveguide; and
- before implementing said epitaxial growth operation, a protective layer (128) is deposited (126) on an upper face of the silicon plate which surrounds the cavity (60), this protective layer (128) being made in a material on which the germanium is not able to grow during said epitaxial growth operation, or, after implementing said epitaxial growth operation, the germanium that has grown on said upper face of the silicon plate which surrounds the cavity is removed.

2. Method for manufacturing a photodiode (2; 190; 200) on a silicon plate extending mainly in a plane referred to as the "plane of the plate", this method including:
- producing (120), on the silicon plate, a first waveguide (22; 192, 194) including a strip (28) that is capable of guiding an optical signal from an input (6) to an output (30);
- producing, on the silicon plate, a germanium slow light waveguide (26; 202) extending along an optical axis from an input (34) that is optically coupled to the output (30) of the first waveguide, this slow light waveguide including:
• a horizontal cross section, parallel to the plane of the plate, that exhibits the same pattern repeated at regular intervals along an optical axis, these patterns being positioned symmetrically on either side of the optical axis in such a way that this arrangement of patterns slows the propagation of an optical signal along the optical axis inside the slow light waveguide, this pattern including two lateral teeth (40) each positioned on a respective side of a germanium central strip (32) or a silicon cylindrical pad (204) that passes from one side of the germanium central strip to the other; and
• two doped regions (72, 76) with opposite signs, positioned on either side of the optical axis so as to capture the charge carriers generated by the optical signal propagating through this slow light waveguide;
**characterized in that** the slow light waveguide (26; 202) is manufactured by implementing the method in accordance with Claim 1.

3. Photodiode manufactured by a method in accordance with Claim 2, this photodiode including:
- a silicon plate (14) extending mainly in a plane referred to as the "plane of the plate";
- a first waveguide (22; 192, 194) including a strip that is capable of guiding an optical signal from an input, intended to receive an optical signal to be detected, to an output, this strip being formed on the plate;
- a germanium slow light waveguide (26; 202) extending along an optical axis from a first input that is optically coupled to the output of the first waveguide, this slow light waveguide including:
• two doped regions (72, 76) with opposite signs, positioned on either side of the optical axis so as to capture the charge carriers generated by the optical signal propagating through this slow light waveguide; and
• a horizontal cross section, parallel to the plane of the plate, that exhibits patterns (40; 204) positioned symmetrically on either side of the optical axis and repeated at regular intervals p along this optical axis so as to slow the propagation of the optical signal through the slow light waveguide, this pattern including two lateral teeth each positioned on a respective side of a germanium central strip or a silicon cylindrical pad that passes from one side of the germanium central strip to the other,
**characterized in that**:
- the photodiode includes a cavity (60) hollowed out of the silicon plate, the bottom (62) of which is located inside the silicon plate and the cross section of which, parallel to the plane of the plate, is identical to the horizontal cross section of the slow light waveguide; and
- the slow light waveguide completely fills this cavity and extends, in a direction perpendicular to the plane of the plate, from the bottom (62) of this cavity up to an upper face located at the same level as or above the upper face of the plate.

4. Photodiode according to Claim 3, in which the photodiode also includes:
- a second waveguide (24) including a strip that is capable of guiding an optical signal from another input (8), intended to receive another optical signal to be detected, to another output, this strip being formed on the plate; and
- the slow light waveguide includes, along the optical axis and on the opposite side to the first input (34), a second input (36) that is optically coupled to the output of the second waveguide.

5. Photodiode according to any one of Claims 3 to 4, in which:
- the slow light waveguide (26) includes a central strip (32) that extends along the optical axis in order to guide the optical signal along this optical axis; and
- the pattern includes the two lateral teeth (40) each positioned on a respective side of the central strip and symmetrical to one another with respect to a longitudinal plane, this longitudinal plane being perpendicular to the plane of the plate and containing the optical axis, the length of each of these teeth being greater than or equal to the width of the central strip, the length of a tooth being equal to the shortest distance between its distal end (44) and the longitudinal plane and the width of the central strip being equal to the shortest distance between two vertical flanks (70) facing each other of the central strip, each located on a respective side of the optical axis and between two successive teeth.

6. Photodiode according to Claim 5, in which the length of more than a third of the teeth is twice greater than or equal to the width of the central strip.

7. Photodiode according to any one of Claims 3 to 6, in which the plate includes doped regions (80, 82) of opposite signs in direct contact with the slow light waveguide, these doped regions of the plate including doped vertical edges (64) of the cavity in direct mechanical and electrical contact with vertical flanks (70) of the slow light waveguide.

8. Photodiode according to any one of Claims 3 to 7, in which the output (30) of the first waveguide is facing and in direct mechanical contact with the first input (34) of the slow light waveguide.

9. Photodiode according to any one of Claims 3 to 8, in which the thickness of the slow light waveguide is equal to the depth of the cavity (60).

10. Photodiode according to any one of Claims 3 to 9, in which the silicon plate (14) extends directly over a dielectric layer (16), itself directly deposited on a substrate (18).
